# EUROPÄISCHE PATENTSCHRIFT

(11) **EP 0 942 639 B1**
(45) Veröffentlichungstag und Bekanntmachung des Hinweises auf die Patenterteilung: **26.03.2003**
(21) Anmeldenummer: 99101954.8
(22) Anmeldetag: 30.01.1999
(51) Int. Cl.: H05K 7/20

(54) **Belüftbarer Elektronikschrank**
Ventilated electronic cabinet
Armoire électronique ventilée

(30) Priorität: 13.03.1998 DE 19810948
(43) Veröffentlichungstag der Anmeldung: 15.09.1999
(73) Patentinhaber: Schroff GmbH, D-75334 Straubenhardt (DE)
(72) Erfinder: Schwenk, Hans-Martin, 75334 Straubenhardt (DE); Kempf, Heinz, 75365 Calw-Altburg (DE); Takats, Peter, 76337 Waldbronn (DE)
(74) Vertreter: Durm, Klaus, Dr.-Ing.

(56) Entgegenhaltungen:
- DE-A- 3 543 486
- "VENTILATUR H LICODE AEREX POUR TIROIRS D' LECTRONIQUE" L'ONDE LECTRIQUE, Bd. 50, Nr. 7, Juli 1970 (1970-07), Seite 646 XP002111955

## Beschreibung

Die Erfindung bezieht sich auf einen belüftbaren Elektronikschrank zur Aufnahme elektrischer und elektronischer Komponenten, mit einer Innenwandung und mit einer Außenwandung, mit einem Axiallüfter, dessen Lüftereingangsöffnung in der Innenwand vorgesehen ist und dessen Lüfterachse senkrecht zur Innenwand steht, mit einem Eintritt für die Frischluft, der in den Zwischenraum zwischen Innenwandung und Außenwandung führt und mit einem Austritt für die Abluft aus dem Zwischenraum.

Elektronikschränke, die doppelwandig ausgebildet sind, gibt es seit vielen Jahren. Die doppelte Wandung ermöglicht den witterungsgeschützten Einsatz solcher Schränke bzw. Gehäuse im Freien. Anwendungsgebiete sind heute insbesondere Telekommunikationseinrichtungen.

Dabei ist es bekannt, den Zwischenraum zwischen der Innen- und der Außenwand zum Zwecke der Isolierung oder Kühlung oder des Wärmetausches zwischen Innen und Außen zu benutzen (DE 348 794, DE 295 19 260, DE 196 23 677, EP-A-0810704).

Zum Zwecke der Abführung der Verlustwärme der eingebauten elektrischen bzw. elektronischen Komponenten werden Ventilatoren eingesetzt, die einen Luftstrom durch die Zwischenräume schicken und die sich erwärmenden Komponenten im Schrankinnern umspülen. Die gleiche Anordnung kann auch benutzt werden, um bei Sonnenstrahlung oder hohen Umgebungstemperaturen eine kühlende Lufthülle um das innere Gehäuse zu legen.

Für den Einbau von Lüftungseinrichtungen in doppelwandige Elektronikschränke steht nur wenig Platz zur Verfügung. Axiallüfter, die notwendigerweise nur in die Innenwand eingesetzt werden können und welche Frischluft anschließend über den engen bis zur Außenwandung hin sich erstreckenden Zwischenraum ansaugen können, erbringen nur einen Bruchteil ihrer Nennleistung, weil die vor der Lüftereingangsöffnung auftretenden Verwirbelungen der anzusaugenden Frischluft einen Großteil der Lüfterleistung nutzlos verbrauchen, so daß der Lüfter nur etwa ein Viertel der normalen Luftmenge fördert. Das Problem kann in den meisten Fällen durch Einbau größerer Lüftungsanlagen aus Platzgründen nicht gelöst werden.

Die Aufgabe der Erfindung besteht in der Verbesserung der Wirksamkeit eines Lüfteraggregates für doppelwandige Elektronikschränke und Elektronikgehäuse.

Zur Lösung der gestellten Aufgabe wird von einem bekannten, belüftbaren Elektronikschrank der eingangs beschriebenen Art ausgegangen. Gelöst wird die Aufgabe durch wenigstens ein Luftleitblech, das im Zwischenraum angeordnet ist und dessen Ebene in Strömungsrichtung der Frischluft steht. Dieses Luftleitblech erstreckt sich über der Lüftereingangsöffnung, liegt in der Ebene der Lüfterachse und seine Höhe entspricht nahezu der Breite des Zwischenraums.

Das vorgeschlagene, vor dem Lüfter angebrachte Luftleitblech verhindert wirksam die Bildung störender Luftwirbel und Druckunterschieden vor den rotierenden Lüfterflügeln. Es hat sich gezeigt, daß eingebaute, mit einem oder auch mehreren nebeneinander stehenden Luftleitblechen versehene Lüftereinheiten nur wenig verringerte Wirkungsgrade zeigen. Das Luftleitblech teilt die angesaugte Frischluft vor dem Lüfter in zwei parallele Luftströme, die getrennt und ohne gegenseitige Beeinflussung den Lüfter passieren.

Zur Erleichterung der Montage sitzt der Axiallüfter an einer ringförmigen Adapterplatte, die an der Innenwandung lösbar befestigt ist.

Zweckmäßig ist das Luftleitblech an der Adapterplatte vorgesehen.

Vorteilhaft ist das Luftleitblech eine ebene, rechteckige Platte aus korrosionsgeschütztem Metall.

In einer Ausgestaltung der Erfindung ist an der Außenwandung eine durch einen lösbaren Deckel verschlossene Service-Öffnung vorgesehen, deren lichte Maße größer sind als die Abmessungen der Adapterplatte. Dies ermöglicht den Austausch eines defekten Axiallüfters ohne den Elektronikschrank öffnen zu müssen und vermeidet die Notwendigkeit, Komponenten während der Reparatur etwa abzuschalten.

Zweckmäßig weisen die Adapterplatte und die Service-Öffnung einen kreisförmigen Grundriß auf.

Eine gute Belüftung ist gewährleistet, wenn der Eintritt für die Frischluft im Bereich des Bodens des Elektronikschrankes zwischen der Innenwandung und der Außenwandung liegt, und der Axiallüfter oberhalb dieses Eintritts vorgesehen ist.

Um das Eindringen von Luftverschmutzungen, Fremdkörpern und Insekten in das Gehäuseinnere wirksam zu verhindern, ist es zweckmäßig, vor der Lüftereingangsöffnung ein austauschbares Luftfilter anzuordnen.

Um eine möglichst große Filterfläche verwirklichen zu können, ist das Luftfilter hohlzylindrisch ausgebildet, es sitzt im Zwischenraum zwischen Innenwandung und Außenwandung und umgibt die Lüftereingangsöffnung. Dieses Luftfilter besitzt somit die Form eines kurzen Rohrstutzens, der in den Zwischenraum eingeklemmt ist.

Vorteilhaft ist ein zylindrisches Stützgitter für das Luftfilter vorgesehen, auf welches das Luftfilter einfach aufgeschoben werden kann.

Zweckmäßig ist das Stützgitter an der Adapterplatte befestigt, es kann aber auch am Deckel der Service-Öffnung angebracht sein.

Um das Luftfilter auch bei laufendem Axiallüfter ohne Gefahr von Verletzungen auswechseln zu können, trägt das Stützgitter ein abnehmbares kreisförmiges Schutzgitter.

Das auf das Stützgitter aufsteckbare Schutzgitter liegt dicht unterhalb des Deckels der Service-Öffnung.

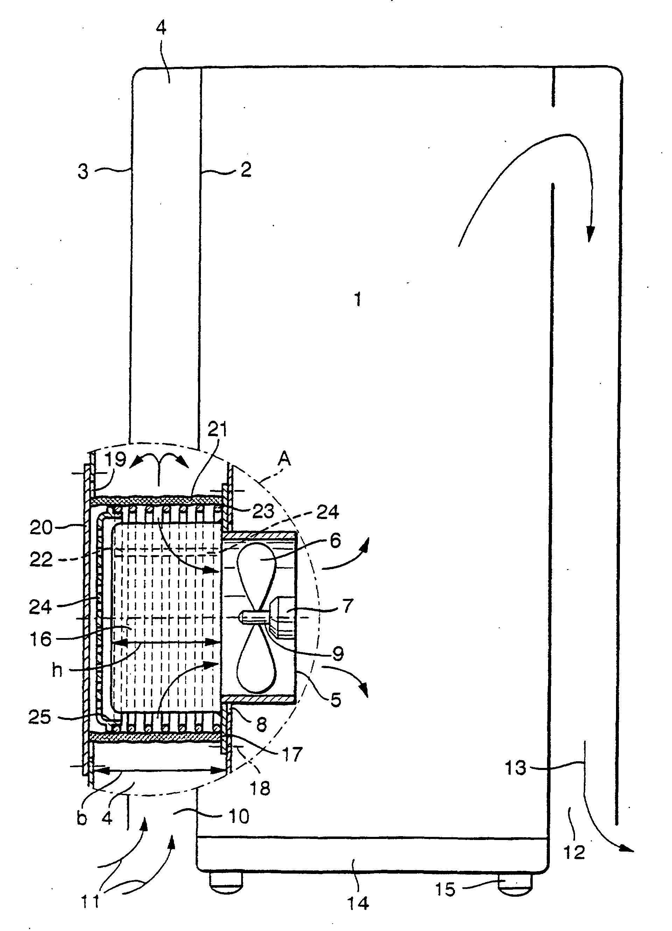

Die Erfindung ist in der Zeichnung dargestellt, die im folgenden erläutert wird. In dieser Zeichnung ist vereinfacht und schematisch ein belüftbarer Elektronikschrank in einem Querschnitt dargestellt. Dabei ist die Belüftungseinrichtung in vergrößertem Maßstab innerhalb des mit Strichlinien A angegebenen Bereiches wiedergegeben.

Der belüftbare Elektronikschrank 1 ist zur Aufnahme von elektrischen und elektronischen Komponenten vorgesehen und wird vorwiegend im Freien eingesetzt.

Der Elektronikschrank 1 ist doppelwandig ausgebildet und besitzt eine Innenwandung 2 und eine Außenwandung 3, die aus korrosionsgeschütztem Stahlblech hergestellt sind. Zwischen Innenwandung 2 und Außenwandung 3 ist ein Zwischenraum 4 gebildet, welcher für Belüftungsmaßnahmen vorgesehen ist.

An der Innenwandung 2 ist ein Axiallüfter 5 mit einem die Lüfterflügel 6 antreibenden Elektromotor 7 angesetzt. Die kreisförmige Lüftereingangsöffnung 8 ist an der Innenwandung 2 vorgesehen, zu welcher die Lüfterachse 9 senkrecht steht.

Ein Eintritt 10 für die von außen angesaugte Frischluft 11 liegt im Bereich des Bodens des Elektronikschrankes und führt in den Zwischenraum 4 zwischen die Innenwandung 2 und die Außenwandung 3. Dieser Eintritt 10 kann durch ein Gitter oder eine Lamellenanordnung (nicht dargestellt) geschützt sein. Der Axiallüfter 5 sitzt oberhalb des Eintritts 10.

Ein Austritt 12 für die erwärmte Abluft aus dem Zwischenraum 4 befindet sich dem Eintritt 10 gegenüber. Beide, Eintritt 10 und Austritt 12, liegen im Bereich des Sockels 14 des Elektronikschrankes 1, der auf niederen Füßen 15 steht.

Vor bzw. über der Lüftereingangsöffnung 8 ist ein Luftleitblech 16 angeordnet, dessen Ebene in der Lüfterachse 9 liegt. Dieses Luftleitblech 16 steht im Zwischenraum 4 zwischen der Innenwandung 2 und der Außenwandung 3 des Elektronikschrankes 1 mit seiner Ebene in Strömungsrichtung der Frischluft 11. Die Höhe h des Luftleitbleches 16 entspricht nahezu der Breite b des Zwischenraumes 4 und teilt den Strom der Frischluft 11 in zwei Hälften, die getrennt von den Lüfterflügeln 6 angesaugt und durch den Axiallüfter 5 hindurchgesaugt werden.

Der handelsübliche Axiallüfter 5 sitzt an einer ringförmigen, flachen Adapterplatte 17, welche an der Innenwandung 2 mit Hilfe von Schrauben 18 lösbar befestigt ist.

Bei dem Luftleitblech 16 handelt es sich um eine ebene, dünne, rechteckige Platte aus einem korrosionsbeständigen Material, nämlich aus oberflächengeschütztem Stahlblech oder auch aus einem geeigneten Kunststoff. Das Luftleitblech 16 ist an der Adapterplatte 17 mit den beiden Außenbereichen seiner Unterkante befestigt.

An der Außenwandung 3 des Elektronikschrankes 1 ist eine Service-Öffnung 19 vorgesehen, die durch einen lösbaren Deckel 20 verschlossen ist. Sie ermöglicht den Zugang zu dem hauptsächlich aus dem Axiallüfter 5 und seinem Zubehör bestehenden Lüftungsaggregat. Die Service-Öffnung 19 und die Adapterplatte 17 sind kreisförmig und die lichten Maße der Service-Öffnung 19 sind etwas größer als der Außendurchmesser der Adapterplatte 17. Dies ermöglicht es, letztere zusammen mit dem Axiallüfter 5 und dem Luftleitblech 16 zum Zwecke des Austausches herauszunehmen.

Vor der Lüftereingangsöffnung 8 ist ein Luftfilter 21 angeordnet, das zur Reinigung oder zum Wechseln austauschbar ist. Dieses Luftfilter 21, welches aus einem filzähnlichen Filtermaterial besteht, ist hohlzylindrisch geformt und ist passend zwischen Innenwandung 2 und Außenwandung 3 in den Zwischenraum 4 eingefügt. Das Luftfilter 21 umgibt die Lüftereingangsöffnung 8 und sitzt mit seinem inneren Rand dicht auf der Adapterplatte 17. Sein äußerer Rand berührt die Innenseite des Deckels 20 der Service-Öffnung 19.

Ein zylindrisches Stützfilter 22 dient als Träger des Luftfilters 21, welches an der Adapterplatte 17 befestigt ist. Es kann alternativ auch an der Innenseite des Deckels 20 angesetzt sein (nicht dargestellt). Das Stützgitter 22 besteht aus einer Anzahl von nebeneinander liegenden Ringen 23 gleichen Durchmessers und von kreisförmigem Querschnitt aus oberflächengeschütztem Material, die von Stäben 24 im Abstand voneinander gehalten werden. Das Luftfilter 21 ist auf das Stützgitter 22 aufgeschoben oder aufgezogen.

Das Stützgitter 22 trägt ein kreisförmiges Schutzgitter 25, welches zum Abnehmen mit seinem hochstehenden Rand 26 in das Stützgitter 22 eingesteckt ist. Das Schutzgitter 25 liegt dicht unterhalb des Deckels 20 der Service-Öffnung 19 und dient als Schutzmaßnahme bei Montagearbeiten bei sich drehenden Lüfterflügeln 6.

### Zusammenstellung der Bezugszeichen

- A: Strichlinie
- 1: Elektronikschrank
- 2: Innenwandung
- 3: Außenwandung
- 4: Zwischenraum
- 5: Axiallüfter
- 6: Lüfterflügel
- 7: Elektromotor
- 8: Lüftereingangsöffnung
- 9: Lüfterachse
- 10: Eintritt
- 11: Frischluft
- 12: Austritt
- 13: Abluft
- 14: Sockel
- 15: Füße
- 16: Luftleitblech
- h: Höhe
- b: Breite
- 17: Adapterplatte
- 18: Schraube
- 19: Service-Öffnung
- 20: Deckel
- 21: Luftfilter
- 22: Stützgitter
- 23: Ring
- 24: Stab
- 25: Schutzgitter
- 26: Rand

## Patentansprüche

1. Belüftbarer Elektronikschrank
- zur Aufnahme elektrischer und elektronischer Komponenten,
- mit einer Innenwandung (2) und
- mit einer Außenwandung (3),
- mit einem Axiallüfter (5),
- dessen Lüftereingangsöffnung (8) in der Innenwand vorgesehen ist, und
- dessen Lüfterachse senkrecht zur Innenwandung steht,
- mit einem Eintritt (10) für die Frischluft, der in den Zwischenraum zwischen Innenwandung und Außenwandung führt, und
- mit einem Austritt (12) für die Abluft aus dem Zwischenraum,
**gekennzeichnet durch**
- wenigstens ein Luftleitblech (16)
- das im Zwischenraum (4) angeordnet ist,
- dessen Ebene in Strömungsrichtung der Frischluft (10) steht,
- welches sich über die Lüftereingangsöffnung (8) erstreckt,
- das in der Ebene der Lüfterachse (9) liegt und
- deren Höhe (h) nahezu der Breite (b) des Zwischenraumes (4) entspricht.

2. Belüftbarer Elektronikschrank nach Anspruch 1, **dadurch gekennzeichnet, daß** der Axiallüfter (5) an einer ringförmigen Adapterplatte (17) sitzt, die an der Innenwandung (2) lösbar befestigt ist.

3. Belüftbarer Elektronikschrank nach Anspruch 1 oder 2, **dadurch gekennzeichnet, daß** das Luftleitblech (16) an der Adapterplatte (17) vorgesehen ist.

4. Belüftbarer Elektronikschrank nach einem der Ansprüche 1 bis 3, **dadurch gekennzeichnet, daß** das Luftleitblech (16) eine ebene, rechteckige Platte aus korrosionsgeschütztem Metall ist.

5. Belüftbarer Elektronikschrank nach einem der Ansprüche 1 bis 4, **dadurch gekennzeichnet, daß** an der Außenwandung (3) eine durch einen lösbaren Deckel (20) verschlossene Service-Öffnung (19) vorgesehen ist, deren lichte Maße größer sind als die Abmessungen der Adapterplatte (17).

6. Belüftbarer Elektronikschrank nach Anspruch 5, **dadurch gekennzeichnet, daß** die Adapterplatte (17) und die Service-Öffnung (19) einen kreisförmigen Grundriß aufweisen.

7. Belüftbarer Elektronikschrank nach einem der Ansprüche 1 bis 6, **dadurch gekennzeichnet , daß** der Eintritt (10) für die Frischluft (11) im Bereich des Bodens des Elektronikschrankes (1) zwischen der Innenwandung (2) und der Außenwandung (3) liegt, und der Axiallüfter (5) oberhalb dieses Eintritts (10) vorgesehen ist.

8. Belüftbarer Elektronikschrank nach einem der Ansprüche 1 bis 7, **dadurch gekennzeichnet, daß** vor der Lüftereingangsöffnung (8) ein austauschbares Luftfilter (21) angeordnet ist.

9. Belüftbarer Elektronikschrank nach Anspruch 8, **gekennzeichnet durch** folgende Merkmale:
- das Luftfilter (21) ist hohlzylindrisch ausgebildet,
- das Luftfilter (21) sitzt im Zwischenraum (4) zwischen Innenwandung (2) und Außenwandung (3), und
- das Luftfilter (21) umgibt die Lüftereingangsöffnung (8).

10. Belüftbarer Elektronikschrank nach Anspruch 8 oder 9, **gekennzeichnet durch** ein zylindrisches Stützgitter (22) für das Luftfilter (21).

11. Belüftbarer Elektronikschrank nach Anspruch 10, **dadurch gekennzeichnet, daß** das Stützgitter (22) an der Adapterplatte (17) befestigt ist.

12. Belüftbarer Elektronikschrank nach Anspruch 10, **dadurch gekennzeichnet, daß** das Stützgitter (22) am Deckel (20) der Service-Öffnung (19) befestigt ist.

13. Belüftbarer Elektronikschrank nach einem der Ansprüche 10 bis 12, **dadurch gekennzeichnet, daß** das Stützgitter (22) ein abnehmbares, kreisförmiges Schutzgitter (25) trägt.

14. Belüftbarer Elektronikschrank nach Anspruch 13, **dadurch gekennzeichnet, daß** das Schutzgitter (25) dicht unterhalb des Deckels (20) der Service-Öffnung (19) liegt.

## Claims

1. Ventilatable electronics cabinet
- for accommodating electrical and electronic components,
- with an inner wall (2) and
- with an outer wall (3),
- with an axial blower (5),
- the blower inlet opening (8) of which is provided in the inner wall, and
- the blower axis of which is perpendicular to the inner wall,
- with an inlet (10) for fresh air leading to the intermediate space between the inner wall and the outer wall, and
- with an outlet (12) from the intermediate space for used air,
**characterised by**
- at least one air baffle plate (16) that is
- arranged in the intermediate space (4),
- the plane of which lies in the direction of flow of fresh air (10),
- which extends over the blower inlet opening (8),
- which lies in the plane of the blower axis (9),
- the height (h) of which approximately corresponds to the width (b) of the intermediate space (4).

2. Ventilatable electronics cabinet according to claim 1 **characterised in that** the axial blower (5) is seated at an annular adapter plate (17) releaseably secured to the inner wall (2).

3. Ventilatable electronics cabinet according to claim 1 or 2 **characterised in that** the air baffle plate (16) is provided at the adapter plate (17).

4. Ventilatable electronics cabinet according to one of claims 1 to 3 **characterised in that** the air baffle plate (16) is a planar, rectangular plate of corrosion-protected metal.

5. Ventilatable electronics cabinet according to one of claims 1 to 4 **characterised in that** a service opening (19) closed by a releaseable lid (20) is provided at the outer wall (3) and its internal dimensions are greater than the dimensions of the adapter plate (17).

6. Ventilatable electronics cabinet according to claim 5 **characterised in that** the adapter plate (17) and the service opening (19) have a circular section.

7. Ventilatable electronics cabinet according to one of claims 1 to 6 **characterised in that** the inlet (10) for the fresh air (11) lies in the region of the floor of the electronics cabinet (1) between the inner wall (2) and the outer wall (3) and the axial blower (5) is provided above this inlet (10).

8. Ventiiatable electronics cabinet according to one of claims 1 to 7 **characterised in that** an exchangeable air filter (21) is arranged in front of the blower inlet opening (8).

9. Ventilatable electronics cabinet according to one of claims 1 to 8 **characterised by** the following features:
- the air filter (21) is formed as a hollow cylinder,
- the air filter (21) is seated in the intermediate space (4) between the inner wall (2) and the outer wall (3), and
- the air filter (21) surrounds the air inlet opening (8).

10. Ventilatable electronics cabinet according to claim 8 or 9, **characterised by** a cylindrical support screen (22) for the air filter (21).

11. Ventilatable electronics cabinet according to claim 10 **characterised in that** the support screen (22) is secured to the adapter plate (17).

12. Ventilatable electronics cabinet according to claim 10 **characterised in that** the support screen (22) is secured to the cover (20) of the service opening (19).

13. Ventilatable electronics cabinet according to one of claims 10 to 12 **characterised in that** the support screen (22) carries a removable, cylindrical protective grill (25).

14. Ventilatable electronics cabinet according to claim 13 **characterised in that** the protective grill (25) lies tightly beneath the cover (20) of the service opening (19).

## Revendications

1. Armoire électronique ventilable
- pour recevoir des composants électriques et électroniques,
- comprenant une paroi intérieure (2) et
- une paroi extérieure (3),
- un ventilateur axial (5),
- dont l'ouverture d'entrée (8) est prévue dans la paroi intérieure, et
- dont l'axe se situe perpendiculairement à la paroi intérieure,
- une entrée (10) pour l'air frais, qui mène dans l'espace intermédiaire entre la paroi intérieure et la paroi extérieure, et
- une sortie (12) pour l'échappement d'air hors de l'espace intermédiaire,
**caractérisée par**
- au moins un déflecteur d'air (16),
- qui est disposé dans l'espace intermédiaire (4),
- dont le plan se situe dans la direction d'écoulement de Pair frais (10),
- qui s'étend sur l'ouverture d'entrée (8) du ventilateur,
- qui se situe dans le plan de l'axe (9) du ventilateur, et
- dont la hauteur (h) correspond à peu près à la largeur (b) de l'espace intermédiaire (4).

2. Armoire électronique ventilable suivant la revendication 1, **caractérisée en ce que** le ventilateur axial (5) repose sur une plaque adaptatrice annulaire (17), qui est fixée de façon amovible sur la paroi intérieure (2).

3. Armoire électronique ventilable suivant l'une des revendications 1 et 2, **caractérisée en ce que** le déflecteur d'air (16) est prévu sur la plaque adaptatrice (17).

4. Armoire électronique ventilable suivant l'une des revendications 1 à 3, **caractérisée en ce que** le déflecteur d'air (16) est une plaque plane rectangulaire en métal protégé contre la corrosion.

5. Armoire électronique ventilable suivant l'une des revendications 1 à 4, **caractérisée en ce que** sur la paroi extérieure (3) est prévue une ouverture de maintenance (19) fermée par un couvercle amovible (20), dont les dimensions intérieures sont plus élevées que les dimensions de la plaque adaptatrice (17).

6. Armoire électronique ventilable suivant la revendication 5, **caractérisée en ce que** la plaque adaptatrice (17) et l'ouverture de maintenance (19) présentent un tracé circulaire.

7. Armoire électronique ventilable suivant l'une des revendications 1 à 6, **caractérisée en ce que** l'entrée (10) pour l'air frais (11) se situe dans la zone du fond de l'armoire électronique (1) entre la paroi intérieure (2) et la paroi extérieure (3), et que le ventilateur axial (5) est prévu au-dessus de cette entrée (10).

8. Armoire électronique ventilable suivant l'une des revendications 1 à 7, **caractérisée en ce qu'**un filtre à air (21) interchangeable est disposé devant l'ouverture d'entrée (8) du ventilateur.

9. Armoire électronique ventilable suivant la revendication 8, **caractérisée par** les particularités suivantes :
- le filtre à air (21) a une configuration cylindrique creuse,
- le filtre à air (21) repose dans l'espace intermédiaire (4) entre la paroi intérieure (2) et la paroi extérieure (3), et
- le filtre à air (21) entoure l'ouverture d'entrée (8) du ventilateur.

10. Armoire électronique ventilable suivant l'une des revendications 8 et 9, **caractérisée par** une grille d'appui cylindrique (22) pour le filtre à air (21).

11. Armoire électronique ventilable suivant la revendication 10, **caractérisée en ce que** la grille d'appui (22) est fixée sur la plaque adaptatrice (17).

12. Armoire électronique ventilable suivant la revendication 10, **caractérisée en ce que** la grille d'appui (22) est fixée sur le couvercle (20) de l'ouverture de maintenance (19).

13. Armoire électronique ventilable suivant l'une des revendications 10 à 12, **caractérisée en ce que** la grille d'appui (22) supporte une grille de protection (25) circulaire amovible.

14. Armoire électronique ventilable suivant la revendication 13, **caractérisée en ce que** la grille de protection (25) se situe juste au-dessous du couvercle (20) de l'ouverture de maintenance (19).
